# EUROPÄISCHE PATENTANMELDUNG

(11) **EP 0 623 998 A1**
(43) Veröffentlichungstag der Anmeldung: **09.11.1994**
(21) Anmeldenummer: 94106766.2
(22) Anmeldetag: 29.04.1994
(51) Int. Cl.: H03K 5/15

(54) **Schaltungsanordnung zur Erzeugung zweier komplementärer Signale**

(30) Priorität: 07.05.1993 DE 4315298
(71) Anmelder: SIEMENS AKTIENGESELLSCHAFT, D-80333 München (DE)
(72) Erfinder: Draxelmayr, Dieter, Dr. Dipl.-Ing., A-9500 Villach (AT)

(57) **Zusammenfassung**

Zur Erzeugung zweier exakt komplementärer Signale werden ein Signal und ein dazu invertiertes Signal über je einen taktgesteuerten Transfertransistor (TN1,TN2) an je einen Inverter (I1,I2) gelegt, die kreuzweise aufeinander rückgekoppelt sind. Die Schaltschwellen der beiden Inverter liegen unterhalb des Mittenpotentials der die Inverter versorgenden Spannung. Ein jedem Inverter nachgeschalteter Auskoppelinverter (I₃,I₄) ermöglicht eine optimale Anpassung an die konkrete Last. Die Schaltung wird vorzugsweise zur Konvertierung von Stromquellenschaltern eingesetzt, beispielsweise in einen Digital-Analog-Umsetzer.

## Beschreibung

Die Erfindung betrifft eine Schaltungsanordnung zur Erzeugung zweier zueinander komplementärer Signale.

Viele Schaltungsanwendungen sehen komplementäre Signale vor, beispielsweise zur Ansteuerung zweier komplementär oder antivalent arbeitender Schalter. Diese Schalter können dazu bestimmt sein, den Strom einer Stromquelle zwischen zwei Zweigen umzuschalten. Um Störeinflüsse während des Umschaltvorganges möglichst klein halten zu können, müssen die beiden Steuersignale der Schalter möglichst exakt komplementär sein. Da die komplementären Signale üblicherweise aus einem einzelnen Signal mit Hilfe eines Inverters erzeugt werden, sind diese insbesondere bei hohen Frequenzen schlecht angepaßt, weil Verzögerungsdifferenzen von einer Gatterlaufzeit auftreten. Es ist möglich, zur Kompensation der Gatterlaufzeit des Inverters ein Transmissiongate zu verwenden. Diese Lösung ist jedoch bei hohen Frequenzen nicht gut genug.

Sehr exakte komplementäre Signale lassen sich mit Stromschaltertechniken realisieren, beispielsweise in der ECL-Technik. Diese Technik ist aufwendig und stromintensiv, da Bipolartransistoren verwendet werden.

Es ist deshalb wünschenswert, aus einem logischen Signal zu einem definierten Zeitpunkt zwei zueinander komplementäre Signale abzuleiten, die auch bezüglich ihres Zeitverlaufs komplementär sind, d. h. gleiche Schaltzeitpunkte und gleiche Flankensteilheiten haben. Dabei soll eine stromsparende Technik zum Einsatz kommen.

Der Erfindung liegt deshalb die Aufgabe zugrunde, eine Möglichkeit zur Erzeugung zweier zueinander komplementärer Signale anzugeben, deren Zeitverhalten optimiert ist. Weiterhin soll eine Verwendung für die komplementären Signale angegeben werden.

Diese Aufgabe wird durch die Mermale der Patentansprüche 1 und 5 gelöst.

Die Erfindung bietet bietet den Vorteil, daß die Schaltungsanordnung einen geringen Aufwand erfordert, daß kein statischer Querstrom fließt und daß sich die erzeugten komplementären Signale bezüglich ihres Zeitverhaltens optimal an eine nachfolgende Lastschaltung anpassen lassen.

Ausgestaltungen der Erfindung sind in Unteransprüchen gekennzeichnet.

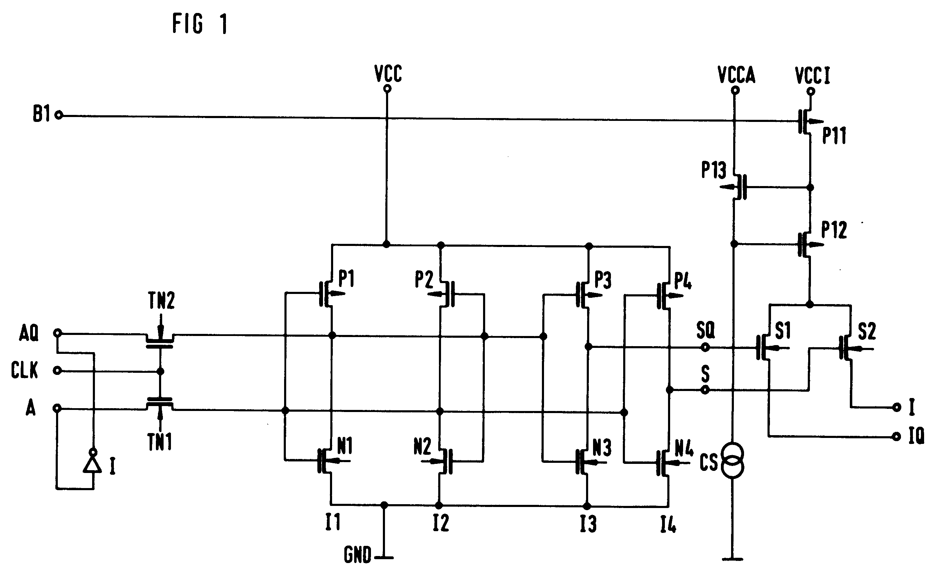

Die Erfindung wird nachfolgend anhand eines in der Figur der Zeichnung dargestellten Beispiels naher erläutert. Gemäß Figur 1 wird die erfindungsgemäße Schaltung von einem Signal A und einem dazu invertierten Signal AQ gespeist. Das Signal AQ kann beispielsweise aus dem Signal A mit Hilfe eines Inverters I erhalten werden. Das Signal A und das dazu invertierte Signal AQ liegen an den gleichgenannten Klemmen an. Über jeweils einen vom gemeinsamen Takt CLK gesteuerten Transfertransistor TN1 bzw.TN2 werden die beiden zueinander invertierten Signale A und AQ zu einem durch den Takt definierten Zeitpunkt weitergeschaltet. Im Fall von n-Kanal-Transfertransistoren erfolgt die Durchschaltung mit der positiven Taktflanke. Während der negativen Taktphase des Taktes CLK können die Eingangsdaten, d. h. die zueinander invertierten Signale gewechselt werden.

Ohne Berücksichtigung physikalischer Effekte werden die beiden Signale A und AQ über die Transfertransistoren TN1 und TN2 theoretisch gleichzeitig weitergegeben. Tatsächlich wird jedoch das negative Signal durch die n-Kanal-Transistoren beim Weiterschalten bevorzugt. Das äußert sich sowohl in einer höheren Geschwindigkeit des negativen Signals (Grenzfrequenz) als auch in einem schlechten Endpegel des positiven Signals.

Die Erfindung sieht deshalb vor, daß den Transfertransistoren TN1 und TN2 ausgangsseitig jeweils ein Inverter I1 bzw. I2 nachgeschaltet sind. Der Inverter I1 enthält die Komplementär-Transistoren P1 und N1, während der Inverter I2 die Transistoren P2 und N2 enthalt. Die Ausgangskreise von P1 und N1 einerseits und von P2 und N2 andererseits sind jeweils in Reihe geschaltet und werden gemeinsam von einer an der Klemme VCC gegen Bezugspotential GND liegenden Spannung versorgt. Die Steueranschlüsse von P1 und N1 sind mit einem Ausgangsanschluß des Transistors TN1 verbunden, und die Steueranschlüsse der Transistoren P2 und N2 sind mit einem Ausgangsanschluß des Transfertransistors TN2 verbunden. Es ist vorgesehen, daß die beiden Inverter I1 und I2 kreuzweise aufeinander rückgekoppelt sind. Dazu ist der Verbindungspunkt der Ausgangskreise der Transistoren P1 und N1 mit dem Steuereingang der Transistoren P2 und N2 verbunden, während der Verbindungspunkt der Ausgangskreise der Transistoren P2 und N1 mit den Steuereingängen der Transistoren P1 und N2 verbunden ist.

Eine Verbesserung der Symmetrie der komplementären Signale läßt sich erzielen, wenn die Schaltpunkte der Inverter I1 bzw. I2 außerhalb des durch die Versorgungsspannung bestimmten Mittenpotentials liegen. Im konkreten Ausführungsbeispiel, in dem P1 und P2 p-Kanal-Transistoren sind und N1 und N2 vom n-Kanal-Typ sind, wird der Schaltpunkt der beiden Inverter unter das Mittenpotential gelegt.

Mit einer durch die Transfertransistoren und die Inverter realisierten Schaltung lassen sich bereits verbesserte zueinander komplementäre Signale erzeugen. Es ist jedoch vorgesehen, daß jedem der Inverter I1 und I2 ein nachgeschalteter Auskoppelinverter I3 bzw. I4 nachgeschaltet ist, die ähnlich wie die vorgenannten Inverter aus komplementären Transistoren P3 und N3 bzw. P4 und N4 aufgebaut sind. Der Ausgang des Inverters I1 ist dabei mit den Steuereingängen der Transistoren P3 und N3 verbunden, während der Ausgang des Inverters I2 mit den Steuereingängen der Transistoren P4 und N4 verbunden ist. Die Inverter I3 und I4 werden ebenfalls von der Versorgungsspannung zwischen VCC und GND versorgt. Die Ausgänge S bzw. SQ der beiden Inverter I4 bzw. I3 bilden die Ausgänge der erfindungsgemäßen Schaltungsanordnung.

Die beiden Inverter I3 und I4 erhöhen die Treiberfähigkeit der Schaltungsanordnung und ermöglichen eine optimale Anpassung der Schaltung an eine konkrete Last.

Im Ausführungsbeispiel steuern die an den Klemmen S und SQ anliegenden, mit der erfindungsgemäßen Schaltung erzeugten zueinander komplementären Signale zwei Schalter S1 bzw. S2, die zu einer Stromzelle eines Digital-Analog-Umsetzers gehören. Die Schalter S1 und S2 konvertieren einen von der Stromquelle P11 und P12 gelieferten Strom zwischen den durch die Schalter definierten Zweigen. Demgemäß führen die Ausgangsanschlüsse der Schaltertransistoren S1 und S2 an den Klemmen IQ bzw. I abwechselnd den Strom der Stromquelle, die im wesentlichen die Transistoren P11 bis P13 enthalten.

Der von einer Vorspannung B1 gesteuerte eigentliche Stromquellentransistor P11 weist einen Kaskodetransistor P12 auf, der so geregelt wird, daß seine Ausgangsanschlüsse voneinander entkoppelt sind. Dazu wird der Verbindungspunkt der Ausgangskreise der Transistoren P11 und P12 mit dem Steueranschluß des Transistors P13 verbunden, der von einer Stromquelle CS gespeist wird und mit einem Ausgangsanschluß an einem Versorgungspotential VCCA angeschlossen ist. Der Verbindungspunkt des Ausgangsanschlusses von P13 mit der Stromquelle CS ist auf den Steueranschluß des Transistors P12 gelegt. Diese Regelung sorgt dafür, daß Spannungsschwankungen, die beim Kommutieren der Schalter S1 und S2 am Verbindungspunkt der Ausgangskreise dieser Schalter mit dem Transistor P12 auftreten können, so ausgeregelt werden, daß der Verbindungspunkt der Transistoren P11 und P12 auf konstantem Potential bleibt. Störeinflüsse durch das Umschalten der Schalter S1 und S2 können sich somit nicht auf den vergleichsweise empfindlich reagierenden Stromquellentransistor P11 und seine Steuerleitung auswirken. Dadurch eignet sich die erfindungsgemäße Schaltungsanordnung mit der nachgeschalteten Stromzelle insbesondere für Digital-Analog-Umsetzer, die eine Vielzahl derartiger Stromzellen benötigen.

## Patentansprüche

1. Schaltungsanordnung zur Erzeugung zweier zueinander komplementärer Signale,
**dadurch gekennzeichnet,**
daß ein Signal (A) und ein dazu invertiertes Signal (AQ) an je einen von einem Takt (CLK) gesteuerten Transfertransistor (TN1, TN2) angelegt sind, daß jeder Transfertransistor ausgangsseitig einen Inverter (I1, I2) steuert und daß die Inverter (I1, I2) kreuzweise rückgekoppelt sind.

2. Anordnung nach Anspruch 1,
**dadurch gekennzeichnet**,
daß die Schaltschwellen der Inverter von einem von einer Versorgungsspannung (VCC-GND) vorgegebenen Mittenpotential abweichen.

3. Anordnung nach Anspruch 1 oder 2,
**dadurch gekennzeichnet**,
daß jedem Inverter (I1, I2) ein Auskoppelinverter (I3, I4) nachgeschaltet ist.

4. Anordnung nach einem der vorhergehenden Ansprüche,
**gekennzeichnet durch** Ausbildung in komplementärer Schaltungstechnik.

5. Verwendung einer Schaltungsanordnung nach einem der vorhergehenden Ansprüche zur Steuerung von Stromzellen in einem Digital-Analog-Umsetzer.
